Europäisches Patentamt

**European Patent Office**

**Office européen des brevets**

(1) Numéro de publication: **0 113 282**
**B1**

(12) **FASCICULE DE BREVET EUROPEEN**

(45) Date de publication du fascicule du brevet: **03.02.88**

(51) Int. Cl.⁴: **H 01 L 23/26**

(21) Numéro de dépôt: **83402489.5**

(22) Date de dépôt: **20.12.83**

(54) Boîtier pour composant électronique comportant un élément fixant l'humidité.

(30) Priorité: **28.12.82 FR 8221871**

(43) Date de publication de la demande:
**11.07.84 Bulletin 84/28**

(45) Mention de la délivrance du brevet:
**03.02.88 Bulletin 88/05**

(84) Etats contractants désignés:
**DE IT**

(56) Documents cités:
**DE-A- 25 647**
**DE-A-3 112 564**
**GB-A-2 057 761**
**US-A-3 391 517**

**IBM TECHNICAL DISCLOSURE BULLETIN,**
**vol.17, no.10, mars 1975, page 2879, New York,**
**(US); L.S.GOLDMANN: "Getter to prevent**
**corrosion"**

(73) Titulaire: **THOMSON-CSF**
**173, Boulevard Haussmann**
**F-75379 Paris Cédex 08 (FR)**

(72) Inventeur: **Val, Christian**
**THOMSON-CSF SCPI 173, bld Haussmann**
**F-75379 Paris Cedex 08 (FR)**

(74) Mandataire: **Benoit, Monique et al**
**THOMSON-CSF SCPI 19, avenue de Messine**
**F-75008 Paris (FR)**

## Description

La présente invention a pour objet un boîtier hermétique pour composant ou circuit électronique, qui comporte un élément assurant l'absorption de l'humidité.

On sait que le contaminant ayant le rôle le plus important — et néfaste — sur le plan de la fiabilité d'un composant, d'un circuit intégré sur une pastille de silicium, ou d'un circuit hybride, est la teneur en eau de l'ambiance environnante. En effet, notamment, l'humidité corrode les plots de connexion des circuits, qui sont généralement en aluminium (par hydrolyse de l'aluminium); elle permet également aux ions de se solubiliser, ce qui renforce la corrosion. Cet effet est très sensible sur les circuits intégrés, et il l'est d'autant plus que l'échelle d'intégration est plus élevée, c'est-à-dire que les plots et connexions sont plus petits.

Il existe plusieurs causes à la présence de molécules d'eau dans un boîtier renfermant un composant ou un circuit électronique. Tout d'abord, si des précautions particulières ne sont pas prises lors de la fermeture du boîtier, celui-ci enferme de l'air ambiant avec son taux d'humidité habituel (couramment de 60 à 70%). Pour diminuer cet effet, il est connu d'éliminer les molécules d'eau autant que possible avant scellement du capot du boîtier et de réaliser ce scellement de façon aussi étanche que possible; cela est réalisé par exemple par brasure étain-or, par scellement verre, sous atmosphère sèche comme de l'azote à moins de 2 ou 3 ppm d'$H_2O$. Toutefois, même dans ces conditions, d'une part il reste des molécules d'eau dans le boîtier et, d'autre part, le boîtier présente toujours des fuites. Lors des variations de température auxquelles sont généralement soumis les boîtiers, il se produit un effet de pompage à travers les fuites: à froid, la dépression intérieure conduit à admettre dans le boîtier de l'air extérieur à humidité ambiante; les molécules d'eau ainsi admises sont au moins partiellement fixées chimiquement (absorption) ou physiquement (adsorption) par les éléments situés à l'intérieur du boîtier (le circuit, l'aluminium, les verres utilisés à la passivation, etc.); lors d'une élévation de température, le gaz rendu à l'extérieur contiendra donc moins de molécules d'eau que celui qui avait été initialement admis. Il apparaît donc que le nombre de molécules d'eau tend à croître à l'intérieur du boîtier.

Il existe également des sources internes à l'accroissement de l'humidité dans le boîtier. Elles sont de deux sortes:

— d'une part, les molécules d'eau adsorbées et absorbées par le circuit et les éléments constitutifs du boîtier vont être libérées au cours de la vie du composant. Pour pallier cet inconvénient, on procède habituellement à un dégazage avant encapsulation à une température voisine de 150°C, mais celui-ci est insuffisant: on sait en effet qu'il est encore possible de trouver des groupements OH à une température supérieure à 1000°C;

— d'autre part, il se produit une génération de molécules d'eau à l'intérieur du boîtier pendant la vie de celui-ci, due notamment à la recombinaison chimique des groupements OH et des protons, à des réactions de dévitrification dans les boîtiers contenant des verres pour les couches de passivation des circuits imprimés, etc.

Une solution connue à ce problème de l'humidité est d'incorporer un circuit électronique assurant la détection de l'humidité et fournissant une alarme lorsque l'humidité à l'intérieur du boîtier dépasse une certaine limite prédéfinie. Lorsque le seuil d'alarme est atteint, le composant est considéré comme hors d'usage et remplacé. Il apparaît donc que cette solution est chère à double titre: d'une part parce qu'elle oblige à incorporer un circuit détecteur au boîtier et, d'autre part, parce qu'elle n'empêche pas que la vie du composant soit limitée par le problème de l'humidité.

Une autre solution connue consiste à incorporer dans le boîtier un matériau susceptible de fixer les molécules d'eau. Cette solution présente une efficacité liée au pouvoir d'absorption du matériau: ainsi qu'il est exposé ci-dessus, d'une part un boîtier présente des fuites et d'autre part il existe des sources internes d'humidité; de la sorte, après un certain temps de fonctionnement, le matériau n'est plus en mesure de fixer les nouvelles molécules d'eau et les inconvénients bien connus réapparaissent.

On connait également du document EP—25 647 des éléments organiques, tel qu'un polysiloxane, susceptibles de fixer des particules présentes dans un boîtier.

La présente invention a pour objet un boîtier permettant d'éviter ces inconvénients grâce à l'incorporation dans ce dernier d'un dispositif susceptible de fixer les molécules d'eau au fur et à mesure de leur entrée ou de leur création dans le boîtier, tout au long de la vie du composant, ainsi que des moyens de chauffage de ce dispositif, assurant son dégazage.

Dans un mode de réalisation, ce dispositif comporte un matériau comportant un métal réactif à l'eau ainsi susceptible de fixer les molécules d'eau; les moyens de chauffage, périodiquement mis en oeuvre, permettant de faire diffuser les atomes de ce métal vers la surface en contact avec l'atmosphère du boîtier, renouvelant ainsi le pouvoir de fixation du matériau.

Plus précisément, l'invention a pour objet un boîtier pour composant électronique tel que défini par la revendication 1.

Il en ressort que le dispositif selon l'invention est de réalisation relativement simple et qu'il permet en outre de prolonger la vie du composant: en effet, les molécules d'eau étant fixées au fur et à mesure de leur création dans un matériau placé à cet effet, elles n'entraîneront pas les détériorations mentionnées plus haut.

D'autres objets, particularités et résultats de l'invention ressortiront de la description qui suit, illustrée par les dessins annexés qui représentent:

— la figure 1, une vue de dessus d'un mode de réalisation du boîtier selon l'invention;

— la figure 2 (a, b et c), des variantes partielles vues de dessus (a) et en coupe (b et c), de la figure précédente;

— la figure 3, une vue en coupe d'un autre mode de réalisation du boîtier selon l'invention.

Sur ces différentes figures, d'une part les mêmes références se rapportent aux mêmes éléments et d'autre part l'échelle réelle n'a pas été respectée, pour la clarté de l'exposé.

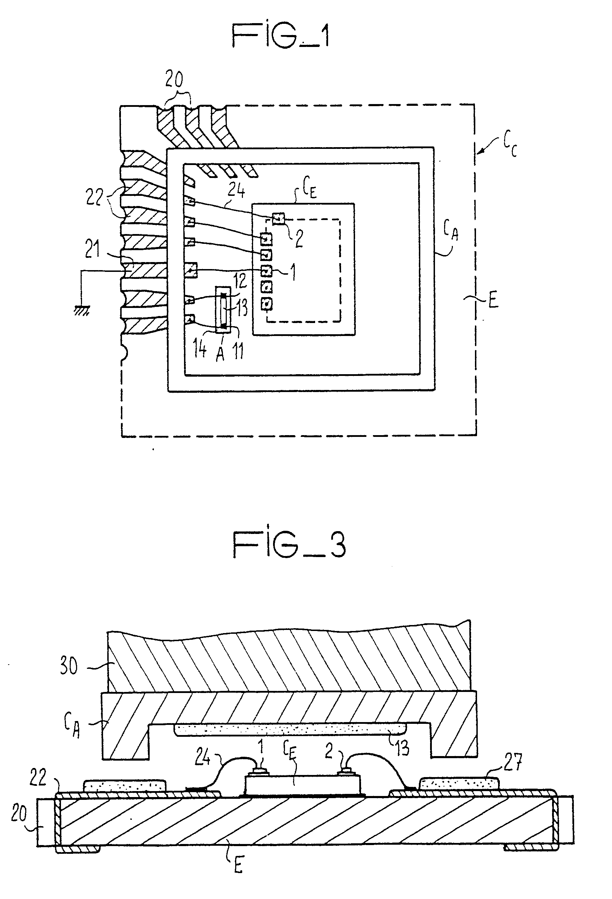

Sur la figure 1, on distingue donc vu de dessus un boîtier, par exemple de type "chip carrier", repéré $C_C$; il est composé d'une embase E part exemple en céramique et d'un capot $C_A$, en métal ou en céramique par exemple, dont on n'a représenté que le trace sur l'embase E.

Sur l'embase E est déposé un composant électronique $C_E$ qui est, dans cet exemple, un circuit intégré réalisé sur une pastille semi-conductrice. Le composant $C_E$ comporte différents plots de connexion tels que 1 et 2, situés à sa périphérie. L'embase E porte un certain nombre de conducteurs sous forme de dépôts métalliques tels que 21 ou 22, qui s'étendent jusqu'à la périphérie de l'embase E. Ainsi qu'il est connu, les dépôts conducteurs se prolongent dans ce type de boîtier a l'intérieur de demi-trous 20, réalisés sur la tranche de l'embase, et s'achèvent sur le dessous de l'embase où ils constituent les connexions de sortie du boîtier. Enfin, les plots de connexion (1, 2) du composant $C_E$ sont reliés aux conducteurs de l'embase (21, 22) par des fils de connexion tels que 24. Il a été représenté en outre, à titre d'exemple, l'un des conducteurs (21) de l'embase reliée à la masse.

Selon l'invention, l'embase porte encore un composant A comportant un élément 13 susceptible de fixer les molécules d'eau.

Dans le mode de réalisation représenté sur la figure 1, le composant A est un composant rapporté sur l'embase, c'est-à-dire que l'élément 13 est déposé sur un substrat 14 sur lequel est réalisé l'ensemble du composant A, ce substrat étant déposé sur L'embase E. Il comporte deux plots de connexion 11 et 12 reliés respectivement à deux des conducteurs tels que 22 portés par l'embase, les plots 11 et 12 étant reliés à un élément conducteur électrique non visible sur la figure, dont la fonction est précisée ci-après.

L'élément fixateur 13 peut être constitué par tout matériau susceptible de fixer des molécules d'eau et ce, de préférence, même lorsque la concentration de ces molécules est très faible. Plus précisément, il peut être constitué par exemple par un verre poreux absorbant connu sous le nom de "Zéolithe" ou encore de "tamis moléculaire" dans la technique des pompes à vide. Afin de rendre maximum la capacité de fixation des molécules d'eau par l'élément 13, il est préférable de lui faire subir un traitement (dégazage) tel que le nombre de molécules d'eau qu'il porte au moment de la fermeture du boîtier soit minimum. Cela est réalisé par apport d'énergie à l'élément 13, par exemple pendant l'opération habituelle de dégazage du boîtier (avant scellement du capot sur l'embase), par tout moyen connu et en particulier dans le mode de réalisation décrit ci-dessus par une résistance chauffante reliée aux plots 11 et 12. L'élément fixateur 13 peut être également constitué par un matériau réactif à l'eau, tel qu'un alliage de métaux, binaire ou terriaire par exemple, dont l'un au moins est réactif à l'humidité, par exemple silicium, titane, zirconium, tantale, vanadium, aluminium, étain etc.; un tel alliage peut être par exemple de l'orsilicium. Dans ce cas, la fixation de l'eau est donc réalisée par réaction chimique.

Selon l'invention, dans ce mode de réalisation, afin de renouveler le pouvoir de fixation des molécules d'eau de l'élément 13, la résistance reliée aux plots 11 et 12 a également pour fonction de chauffer l'élément 13 de temps à autres, après fermeture du boîtier, afin de permettre aux atomes du métal réactif de diffuser vers la surface en contact avec l'atmosphère duboîtier, à travers la couche d'oxyde déjà formée, renouvelant le pouvoir de fixation de l'élément 13.

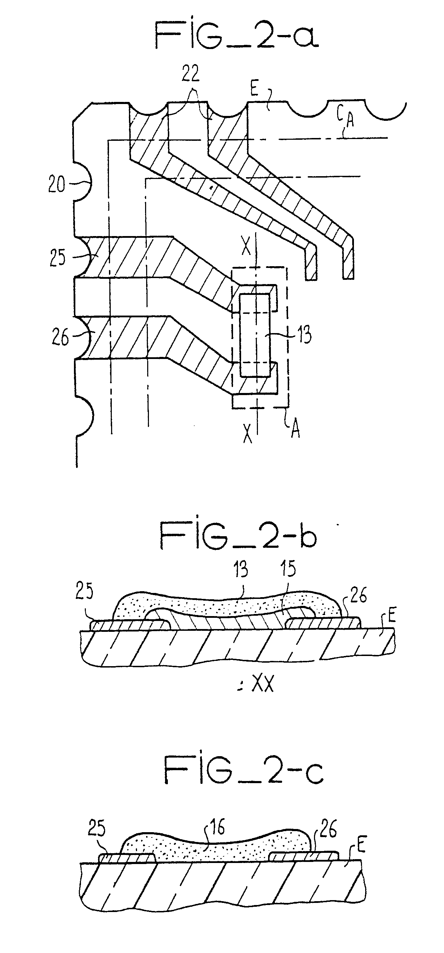

La figure 2a représente une vue partielle de dessus d'une variante de réalisation de la figure précédente. Sur cette figure, on retrouve une portion de l'embase E, la trace du capot $C_A$, et quelques conducteurs tels que 22 parmi lesquels deux qui sont repérés 25 et 26.

Selon la variante de la figure 2b, qui représente une vue en coupe réalisée selon l'axe XX de la figure 2a, la résistance est constituée par un matériau résistif repéré 15, déposé directement sur l'embase E et partiellement sur l'extrémité des conducteurs 25 et 26, par exemple par sérigraphie; il est recouvert, après cuisson, par le matériau constituant l'élément fixateur 13, qui est seul visible sur la venue de dessus de la figure 1 ou de la figure 2a, et qui peut être également déposé par sérigraphie.

Dans le cas où l'élément fixateur 13 est un alliage métallique, on isole électriquement le matériau résistif 15 de l'alliage, par exemple par une mince couche de verre (non représentée sur les figures).

Selon une autre variante, représentée sur la figure 2c, vue en coupe toujours selon l'axe XX, on utilise un matériau fixateur qui est en même temps conducteur, ce qui évite la couche résistive 15: dans ce cas, ce matériau, repéré 16, est directement déposé sur l'embase E et l'extrémité des conducteurs 25 et 26. Le matériau 16 peut être réalisé à partir d'un matériau résistif tel qu'une encre de sérigraphie à base d'oxyde de Ruthénium, d'Argent Palladium, d'Argent Platine, etc. dont on accroît la surface spécique, réalisant ainsi un matériau poreux susceptible de fixer les molécules d'eau.

Il est également possible d'éviter la couche résistive 15 lorsque l'élément fixateur 13 est un alliage métallique: il suffit de choisir les composants de l'alliage de façon à obtenir un composé résistif.

Dans l'une ou l'autre des variantes décrites ci-dessus, le composant A ne nécessite qu'une seule connexion 22 laissée libre par le composant électronique $C_E$, la seconde connexion pouvant être la connexion 21 de masse.

La figure 3 représente un autre mode de réalisation du boîtier selon l'invention, vu en coupe longitudinale.

Sur cette figure, on retrouve l'embase E portant le composant $C_E$. Celui-ci est relié électriquement par ses plots 1 et 2 et par l'intermédiaire de fils de connexion 24 aus conducteurs 22 de l'embase E, passant dans les demi-trous 20. Le boîtier comporte encore un capot $C_A$, destiné à être scellé sur l'embase E par l'intermédiaire d'un verre de scellement 27.

Dans ce mode de réalisation, le matériau fixateur 13 est porté par l'intérieur du capot $C_A$ où il est déposé par exemple par sérigraphie.

L'avantage de cette variante par rapport aux précédentes est double. Le premier aspect est que le matériau 13 peut y être déposé en plus grande quantité que sur l'embase elle-même, et le second aspect est la possibilité de réaliser de façon simple l'apport d'énergie au matériau 13 préalablement au scellement du capot $C_A$ sur l'embase E. En effet, ainsi qu'il est connu, cette opération de scellement nécessite un chauffage du capot soit dans un four, soit localement. Lorsque le chauffage est réalisé localement, le capot est chauffé par un outil 30 à une température de l'ordre de 500° à 650°, opération qui entraîne donc également le chauffage de la couche 13 et le dégazage recherché.

Dans le case où on utilise un matériau réactif à l'eau, on prévoit comme précédemment des moyens de chauffage du matériau fixateur pour permettre aux atomes de matériau réactif de diffuser vers la surface en contact avec l'atmosphère du boîtier.

Bien entendu, les différents modes de réalisation décrits ci-dessus peuvent être utilisés cumulativement.

Par ailleurs, l'invention n'est pas limitée aux modes de réalisation décrits ci-dessus. C'est ainsi par exemple qu'il a été décrit un boîtier de type "chip carrier" plan portant une seule pastille de silicium mais l'invention est applicable à tout type de boîtier (DIL, CERDIP, etc.) plan ou à plusieurs niveaux, que ce soit pour composant discret, pour circuit intégré ou pour circuit hybride, et le terme de "composant" est utilisé dans la présente demande par simplification, étant entendu qu'il désigne l'un quelconque de ces trois éléments. De même, le boîtier décrit ci-dessus comme étant en céramique ou métal, peut être en plastique, en totalité ou partiellement (embase ou capot). Egalement, l'apport d'énergie nécessaire au dégazage (avant fermeture du boîtier) du matériau fixateur des atomes d'eau peut-être réalisé autrement que par chauffage, par exemple par irridation ultra-violette.

## Revendications

1. Boîtier pour composant électronique, comportant une embase destinée à recevoir le composant et un capot recouvrant le composant et fixé sur l'embase de façon étanche, le boîtier comportant en outre un élément assurant la fixation de particules, disposé à l'intérieur de boîtier, celui-ci étant caractérisé par le fait que l'élément de fixation comporte un matériau réactif à l'eau (13, 16), assurant ainsi la fixation des molécules d'eau, et des moyens de chauffage de cet élément de fixation, susceptibles d'être périodiquement mis en oeuvre afin de renouveler la couche de l'élément de fixation en contact avec l'atmosphère du boîtier, les moyens de chauffage comportant un matériau électriquement résistif (15) en contact thermique avec l'élément de fixation (13), et l'embase (E) comportant des connexions électriques (21, 22) assurant la liaison entre l'intérieur et l'extérieur du boîtier, le matériau résistif (15) étant relie à deux de ces connexions.

2. Boîtier selon la revendication 1, caractérisé par le fait que l'élément de fixation (13, 16) est porté par un substrat (14) disposé sur l'embase (E) ou sur le capot ($C_A$).

3. Boîtier selon la revendication 1, caractérisé par le fait que l'élément de fixation (13, 16) est porté directement par l'embase (E) ou par le capot ($C_A$).

4. Boîtier selon l'une des revendications précédentes caractérisé par le fait que le matériau résistif forme une couche (15) distincte de l'élément de fixation (13), disposée sous ce dernier.

5. Boîtier selon l'une des revendications 1 à 3, caractérisé par le fait que le matériau résistif est incorporé à l'élément de fixation (16).

6. Boîtier selon l'une des revendications 1 à 4, caractérisé par le fait que l'élément fixateur (13) comporte du zéolithe.

7. Boîtier selon la revendation 5, caractérisé par le fait que l'élément fixateur (16) est un matériau poreux comportant une encre de sérigraphie et un matériau électriquement conducteur.

8. Boîtier selon l'une des revendications 1 à 5, caractérisé par le fait que l'élément fixateur comporte un matériau chimiquement réactif à l'eau.

9. Boîtier selon la revendication 8, caractérisé par le fait que le matériau réactif est un métal.

10. Boîtier selon l'une des revendications 8 à 9, caractérisé par le fait que les moyens de chauffage de l'élément fixateur sont reliés électriquement à l'extérieur du boîtier et sont ainsi susceptible d'être mis en oeuvre à plusieurs reprises après la fermeture du boîtier.

## Patentansprüche

1. Gehäuse für ein elektronisches Bauteil mit einer Basis, auf der das Bauteil liegt, und einer Haube, die das Bauteil überdeckt und auf der Basis dicht befestigt ist, wobei das Gehäuse außerdem im Inneren ein die Fixierung von Partikeln sicherndes Element enthält, dadurch gekennzeichnet, daß das Fixierelement ein mit Wasser reagierendes Material (13, 16), das also die Fixierung von Wassermolekülen sichert, und Heizmittel zum Erwärmen des Fixierelements aufweist, die periodisch eingeschaltet werden können, um die mit der Atmosphäre im Gehäuse in Berührung stehende Schicht des Fixierelements zu erneuern, wobei die Heizmittel ein elektrisches Widerstandsmaterial (15) in thermischem Kontakt mit dem Fixierelement (13) besitzen und die Basis (E) elektrische Anschlüsse (21, 22) aufweist, die die Verbindung zwischen der Innen — und der Außenseite des Gehäuses bewirken, wobei das Widerstandsmaterial (15) mit zwei dieser Anschlüsse verbunden ist.

2. Gehäuse nach Anspruch 1, dadurch gekennzeichnet, daß das Fixierelement (13, 16) von einem Substrat (14) getragen wird, das auf der Basis (E) oder der Haube $(C_A)$ angeordnet ist.

3. Gehäuse nach Anspruch 1, dadurch gekennzeichnet, daß das Fixierelement (13, 16) unmittelbar von der Basis (E) oder der Haube $(C_A)$ getragen wird.

4. Gehäuse nach einem der vorhergehenden Ansprüche, dadurch gekennzeichnet, daß das Widerstandsmaterial eine vom Fixierelement (13) getrennte Schicht (15) bildet, die unterhalb des Fixierelements angeordnet ist.

5. Gehäuse nach einem der Ansprüche 1 bis 3, dadurch gekennzeichnet, daß das Widerstandsmaterial in das Fixierelement (16) integriert ist.

6. Gehäuse nach einem der Ansprüche 1 bis 4, dadurch gekennzeichnet, daß das Fixierelement (13) einen Zeolith enthält.

7. Gehäuse nach Anspruch 5, dadurch gekennzeichnet, daß das Fixierelement (16) ein poröses Material ist, das eine Seriegraphietinte und ein elektrisch leitendes Material enthält.

8. Gehäuse nach einem der Ansprüche 1 bis 5, dadurch gekennzeichnet, daß das Fixierelement ein chemisch mit Wasser reagierendes Material ist.

9. Gehäuse nach Anspruch 8, dadurch gekennzeichnet, daß das reaktive Material ein Metall ist.

10. Gehäuse nach einem der Ansprüche 8 bis 9, dadurch gekennzeichnet, daß die Heizmittel für das Fixierelement elektrisch aus dem Gehäuse herausgeführt sind, so daß sie mehrfach nach dem Verschließen des Gehäuses in Betrieb genommen werden können.

## Claims

1. A housing for an electronic component, comprising a base intended to receive the component, and a cap covering the component and fixed in a sealed manner to the base, the housing further comprising an element which ensures the fixation of particles and which is disposed inside the housing, characterized in that the fixation element comprises a water-reactive material (13, 16) thus ensuring the fixation of water molecules, and heating means for heating up the fixation element, which means can be activated periodically in order to renovate the fixation element layer in contact with the atmosphere of the housing, the heating means comprising an electric resistor material (15) in thermal contact with the fixation element (13), and the base (E) comprising electrical connections (21, 22) which ensure the connection between the inside and the outside of the casing, the resistor material (15) being connected to two of these connections.

2. A housing according to claim 1, characterized in that the fixation element (13, 16) is carried by a substrate (14) disposed on the base (E) or on the cap $(C_A)$.

3. A housing according to claim 1, characterized in that the fixation element (13, 16) is carried directly by the base (E) or by the cap $(C_A)$.

4. A housing according to one of the preceding claims, characterized in that the resistor material constitutes a layer (15) which is distinct from the fixation element (13) and disposed beneath the latter.

5. A housing according to one of claims 1 to 3, characterized in that the resistor material is incorporated into the fixation element (16).

6. A housing according to one of claims 1 to 4, characterized in that the fixation element (13) comprises a zeolite.

7. A housing according to claim 5, characterized in that the fixation element (16) is a porous material comprising a serigraphic ink and an electrically conducting material.

8. A housing according to one of claims 1 to 5, characterized in that the fixation element comprises a material which reacts chemically with water.

9. A housing according to claim 8, characterized in that the reactive material is a metal.

10. A housing according to one of claims 8 and 9, characterized in that the heating means for heating up the fixation element are electrically connected to the outside of the casing and are thus capable of being activated several times after the sealing of the housing.

# FIG_1

# FIG_3

## FIG_2-a

## FIG_2-b

: XX

## FIG_2-c